# EUROPEAN PATENT APPLICATION

(11) **EP 2 725 884 A1**
(43) Date of publication of application: **30.04.2014**
(21) Application number: 12802801.6
(22) Date of filing: 11.06.2012
(51) Int. Cl.: H05K 9/00

(54) **SHIELD FRAME, SEALED FRAME MOUNTING STRUCTURE, AND ELECTRONIC PORTABLE DEVICE**

(30) Priority: 23.06.2011 JP 2011139863
(71) Applicant: NEC CASIO Mobile Communications, Ltd., Kawasaki-shi, Kanagawa 211-8666 (JP)
(72) Inventor: OGATSU Toshinobu, Kawasaki-shi Kanagawa 211-8666 (JP)
(74) Representative: Vossius & Partner
(86) International application number: PCT/JP2012/064928
(87) International publication number: WO 2012/176646

(57) **Abstract**

A shield frame includes a side plate part that extends so as to be arranged vertically from a circuit board, on which electronic components are mounted, and to surround lateral sides of the electronic components. The side plate part has a base end part that faces the circuit board, and the base end part has a flangeless structure and functions as an end part fixed to the circuit board by soldering. Preferably, the shield frame is made of metal and is formed by a drawing process.

## Description

### TECHNICAL FIELD

The present invention relates to a shield frame mounted on a circuit board of an electronic device, a shield frame mounting structure, and an electronic portable device. In particular, the present invention relates to a structure of circuit boards that realizes downsizing and thinning of the relevant device.

Priority is claimed on Japanese Patent Application No. 2011-139863, filed June 23, 2011, the contents of which are incorporated herein by reference.

### BACKGROUND ART

In recent years, portable devices such as cellular phones, portable information terminals, or notebook-size personal computers have acquired improved functions accompanied with advance in the respective portable devices. Therefore, too many components or parts are arranged on a circuit board so as to candle added functions. Additionally, in any portable terminal for such devices, electronic components such as an antenna for a cellular phone network, a TV antenna, a Bluetooth antenna, a GPS antenna, an RFID antenna, and the like, which emit radio waves that are directed to different purposes and have different frequencies, are mounted side by side. Furthermore, the operation clock frequency for LSIs has increased generally. Therefore, mutual interference has become a problem.

In order to solve the problem, a shield member is used to provide electromagnetic shielding between electronic components. Since such a shield member is designed to cover each electronic component, the size of the shield member often affects the size of the relevant product. Therefore, in order to perform the downsizing of devices, downsizing of the shield member and peripherally mounted parts therefor is also required. Accordingly, a technique for downsizing while securing a desired electromagnetic shielding performance has been developed.

In addition, although such shielding should be individually applied to each function or operation frequency, a single large shielding structure may be employed together with partition plates that partition the shielded area into sections.

For such a shield member or component and a mounting structure therefor, Patent-Document 1 proposes a known example.

### PRIOR ART DOCUMENT

### Patent Document

Patent Document 1: Japanese Unexamined Patent Application, First Publication No. 2006-196664.

### DISCLOSURE OF INVENTION

### Problem to be Solved by the Invention

Patent Document 1 discloses a shield component that is fabricated by cutting and folding a metal plate, which produces a gap that degrades sealing performance. That is, despite the necessity of electrical sealing, a slight gap is generated at a corner of a shape that is produced by simply folding a metal plate.

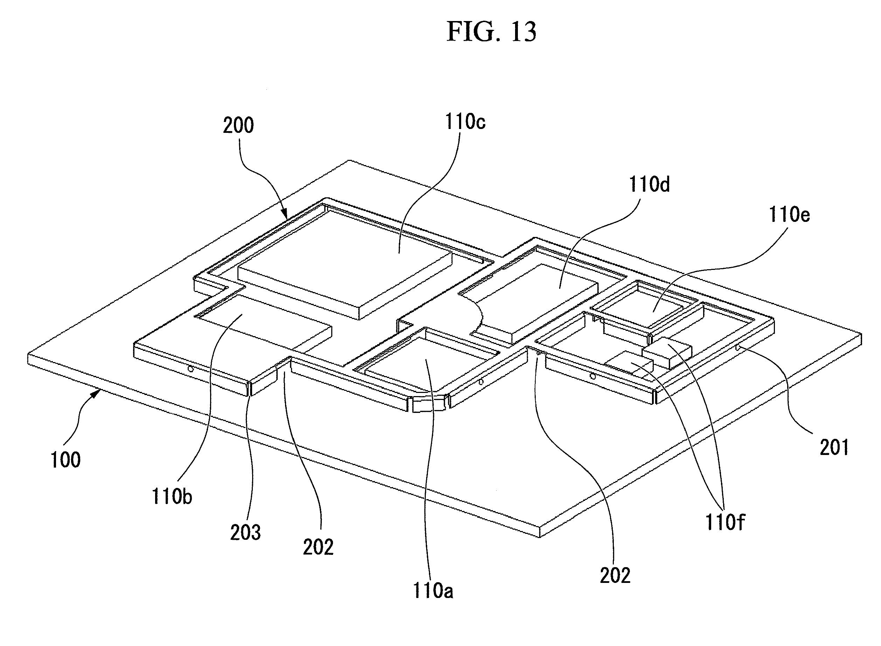

The above problem will be explained in detail with reference to Figs. 13 to 16E. For a complex shape as shown in Fig. 13, in particular, two opposing sides of each inner corner cannot be established by means of the folding, so that one of the walls of the corner should have a hole whose size corresponds to the height of the wall. A specific example thereof will be explained below.
Fig. 13 is a perspective view of a mounting board on which a shield frame having a folded structure is mounted. On a circuit board 100, a shield frame 200 having the folded structure, semiconductor components 110a to 110f, and other semiconductor components or electronic components (not shown) are mounted.

The folded shield frame 200 has protrusions 201 that are fit to a cover, inner corner cutouts 202, and outer corner joints 203. Since the folded structure is made by folding a flat plate, each inner corner cutout 202 is produced because any one of the walls cannot be formed at the relevant inner corner. Additionally, each outer corner should have a joint, which technically produces a gap.

Fig. 14 shows a state in which a frame cover 300 is attached. Between the folded shield frame 200 and the cover 300, the protrusions 201 of the folded shield frame 200 are fit into fitting holes 301 of the cover 300. In addition, contacts 302 utilized to electrically connecting the cover 300 and the shield frame 200 are provided.

Figs. 15A and 15B are diagrams that show the mounted structure when the cover 300 is attached. Fig. 15A is a plan view. Fig. 15B shows a view observed along an arrow A in Fig. 15A, and an enlarged view of a main part thereof.

Even when the cover is attached as described above, it cannot reach the bottom surface of the mounting board (i.e., the relevant surface of the circuit board 100) because of solder areas of the cover 300. Therefore, parts corresponding to the inner corner cutouts 202 made holes, which degrades the shielding performance.

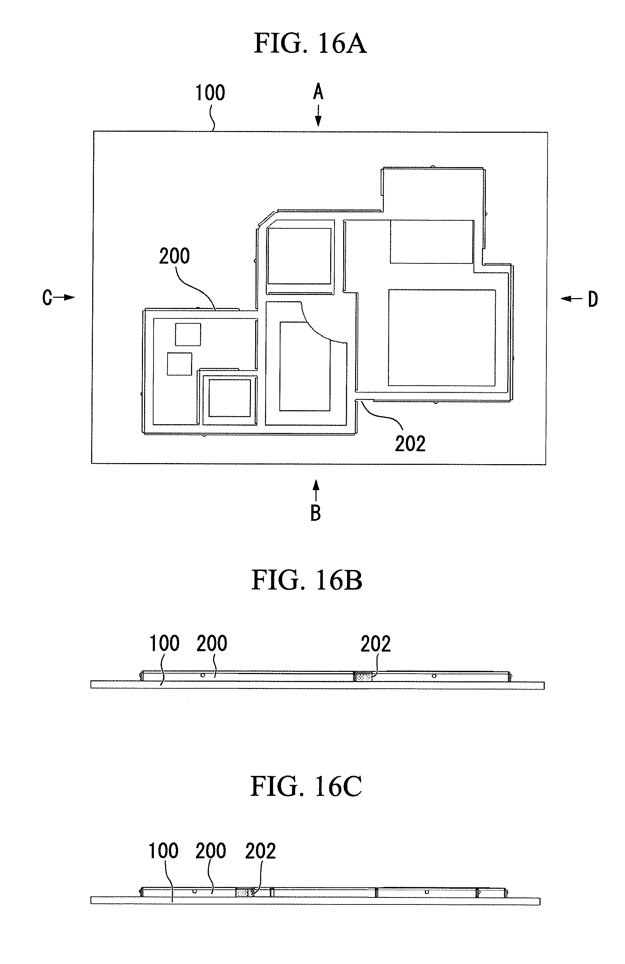

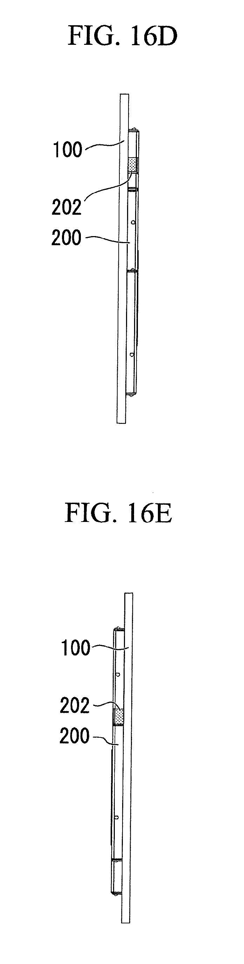

Figs. 16A and 16E are diagrams that show the mounted structure in Fig. 13 from different directions. Fig. 16A is a plan view. Fig. 16B is a view observed along an arrow A in Fig. 16A. Fig. 16C is a view observed along an arrow B in Fig. 16A. Fig. 16D is a view observed along an arrow C in Fig. 16A. Fig. 16E is a view observed along an arrow D in Fig. 16A.

As shown in the above figures, parts corresponding to the inner corner cutouts 202 degrade the shielding performance similarly.

Here, the above-described Patent-Document 1 teaches a shield component fabricated by a drawing process. Probably due to such a process, edge parts of the shield component, which face a circuit board, are odd-shaped. Therefore, if only a part of the shield component is fastened to the circuit board, a gap is generated at the odd-shaped part, and thus sufficient shielding performance cannot be obtained also in this case.

In order to solve the above problem, an object of the present invention is to provide a shield frame, a shield frame mounting structure, and an electronic portable device, by which high shielding performance, thinning of shield components, and high mounting density of mounted components are realized by a simplified shape of the shield frame.

### Means for Solving the Problem

In order to achieve the above object, the present invention employs the following structure. That is, the present invention provides a shield frame that has a side plate part that extends so as to be arranged vertically from a circuit board, on which electronic components are mounted, and to surround lateral sides of the electronic components, wherein the side plate part has a base end part that faces the circuit board, and the base end part has a flangeless structure and functions as an end part fixed to the circuit board by soldering.

### Effect of the Invention

As a first effect of the present invention, reliable electromagnetic shielding is possible even for a large shield frame having a complex form.

As a second effect of the present invention, both the reliable electromagnetic shielding and downsizing can be realized for a large shield frame.

As a third effect of the present invention, the relevant structure can be implemented utilizing a mounting area equivalent to that in conventional shield frames fabricated by a folding process.

As a fourth effect of the present invention, simple waterproofing inside the shield frame can be performed.

### BRIEF DESCRIPTION OF THE DRAWINGS

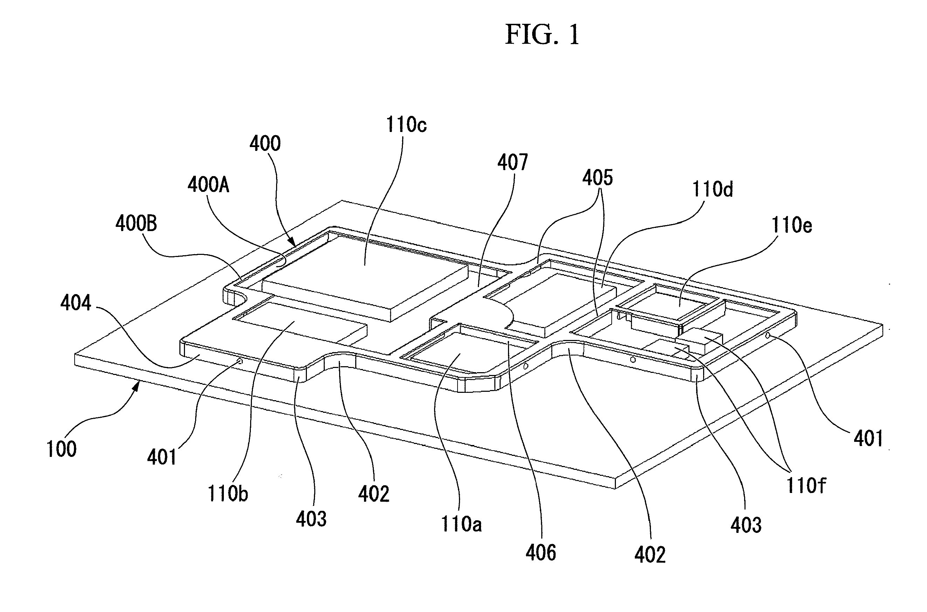

Fig. 1 is a perspective view of a general structure of a shield frame mounting structure as an embodiment in accordance with the present invention.

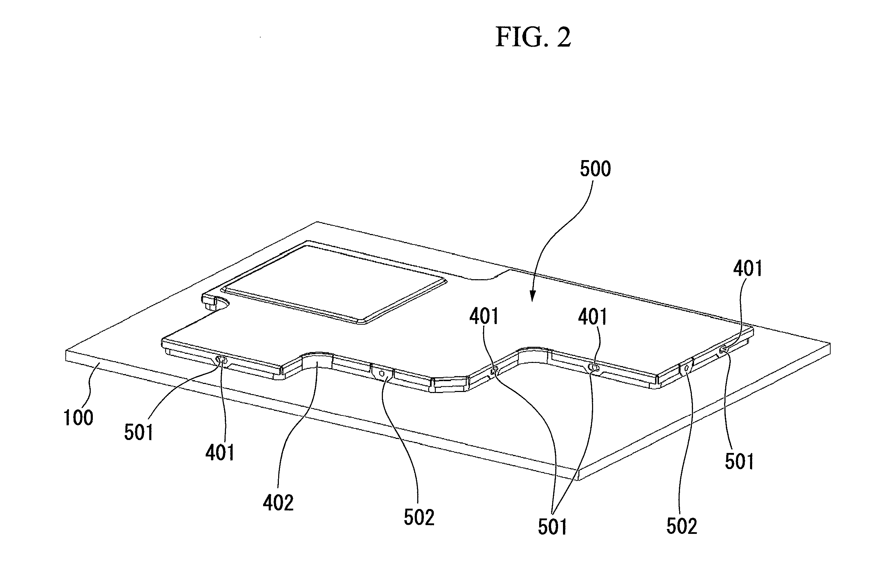

Fig. 2 is a perspective view of the mounting structure shown in Fig. 1, to which a cover is attached.

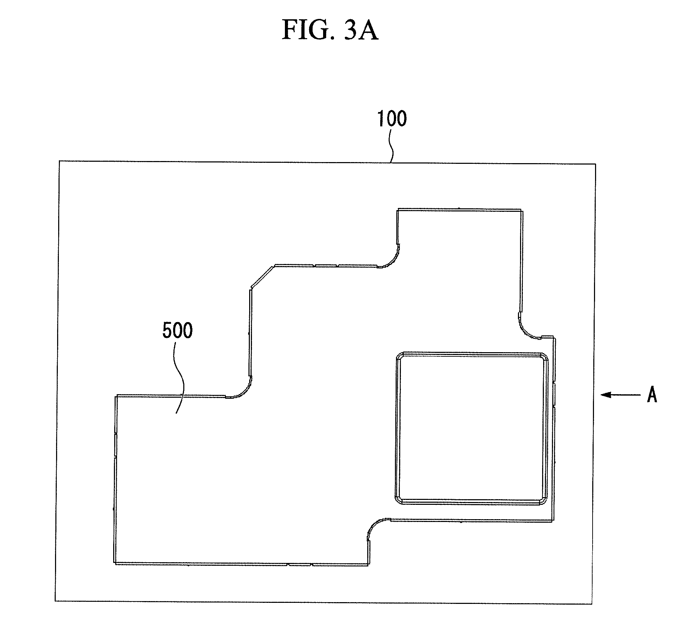

Fig 3A is a plan view of the mounting structure shown in Fig. 2.

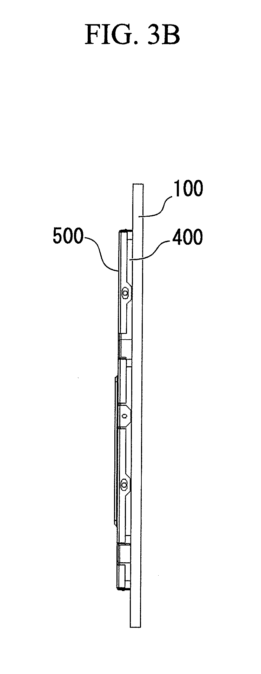

Fig. 3B is a view observed along an arrow A in Fig. 3A.

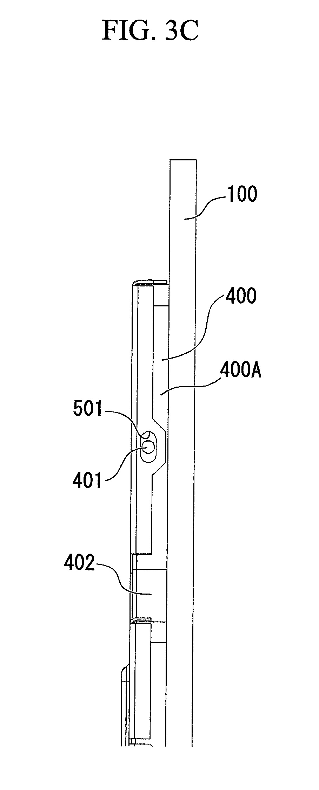

Fig. 3C is an enlarged view of a main part of Fig 3A.

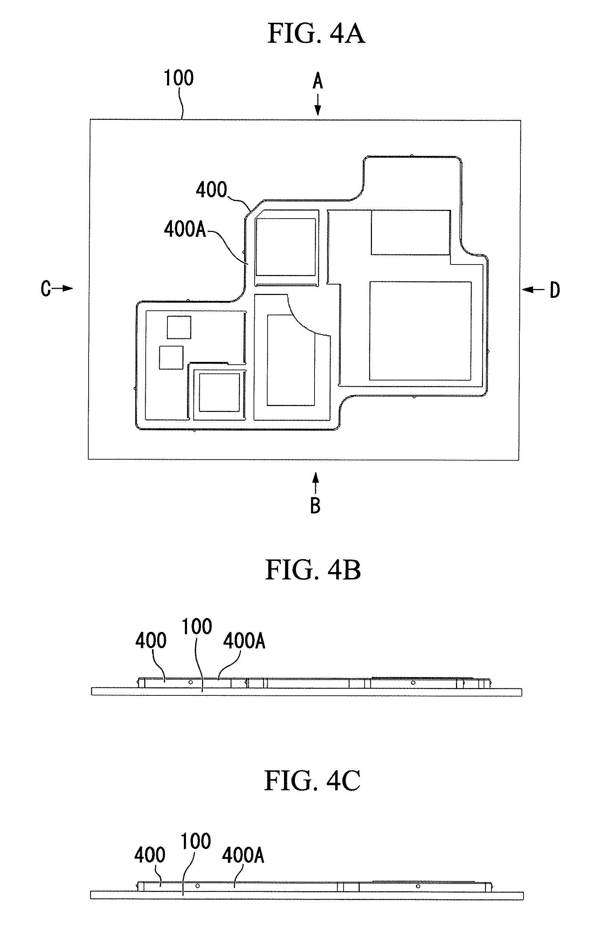

Figs. 4A is a plan view of the mounting structure in Fig. 1 from a different direction.
Fig. 4B is a view observed along an arrow A in Fig. 4A.
Fig. 4C is a view observed along an arrow B in Fig. 4A.

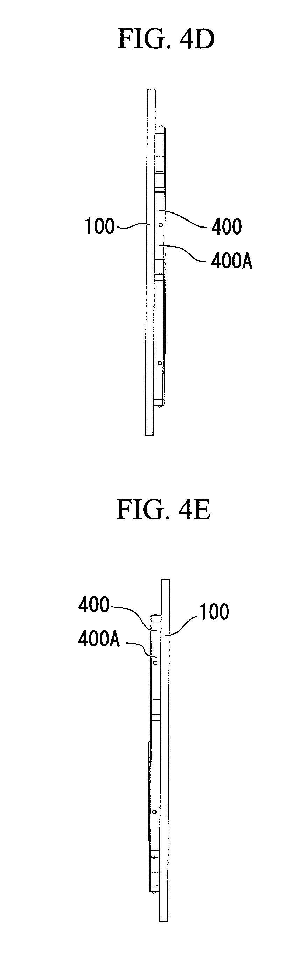

Fig. 4D is a view observed along an arrow C in Fig. 4A.
Fig. 4E is a view observed along an arrow D in Fig. 4A.

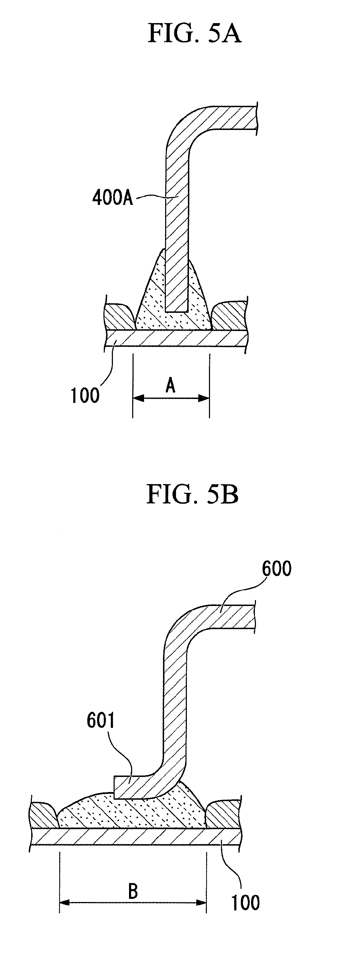

Fig. 5A is a diagram that shows a soldered part in the mounting structure in Fig. 1.
Fig. 5B is a diagram that shows a soldered part in a conventional mounting structure as a comparative example for Fig. 5A.

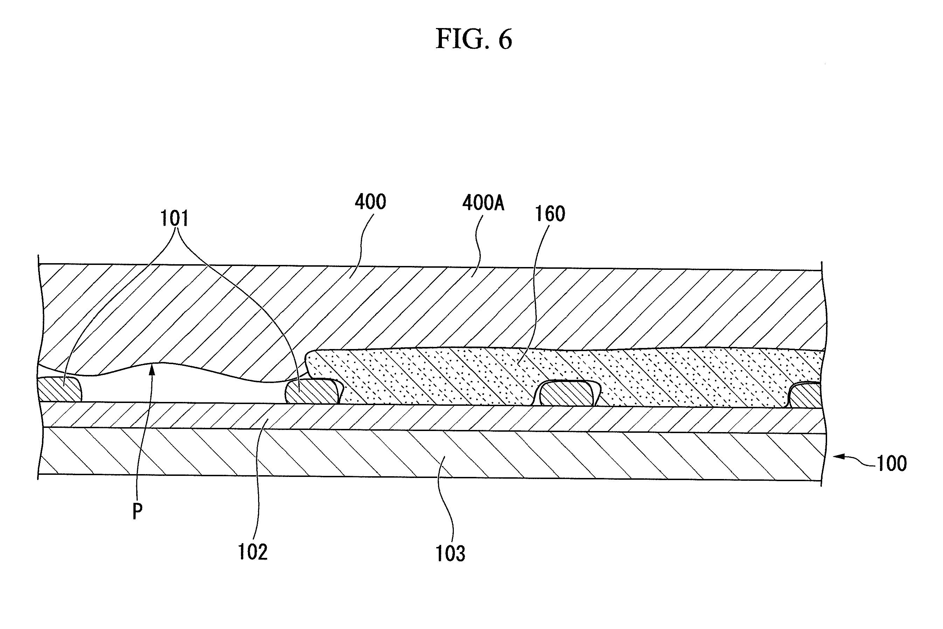

Fig. 6 is a sectional view that shows a soldered part at the shield frame of the mounting structure in Fig. 1.

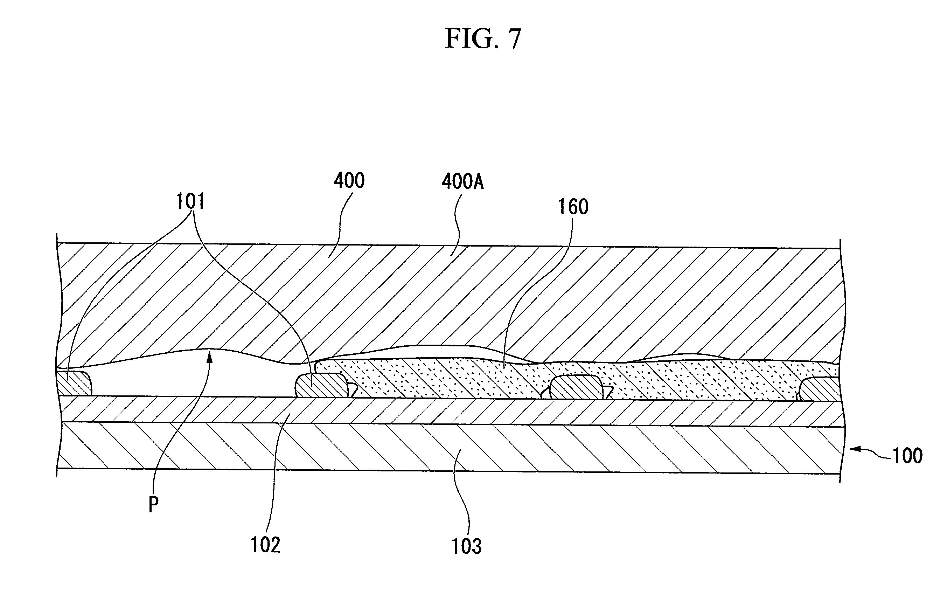

Fig. 7 is a sectional view of a mounting structure that employs a normal amount of solder, in comparison with the shield frame of the mounting structure in Fig. 1.

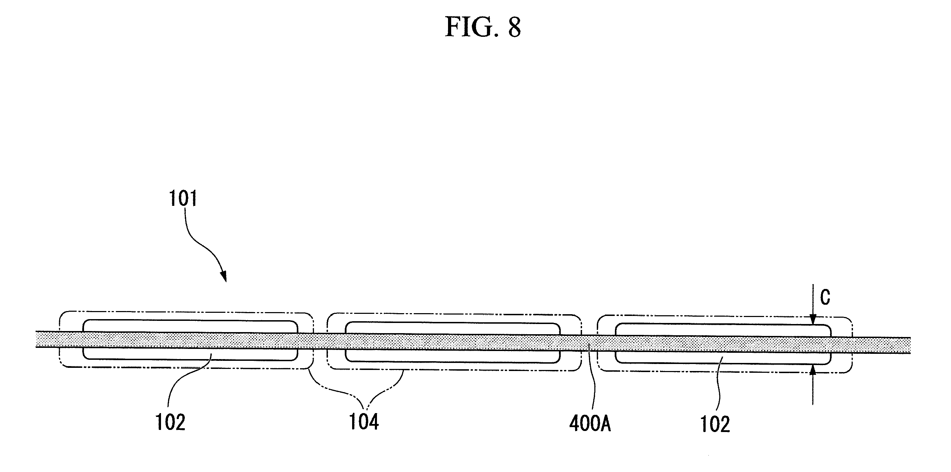

Fig. 8 is a plan sectional view that shows an outer wall of the shield frame of the mounting structure in Fig. 1 and a footprint pattern therefor.

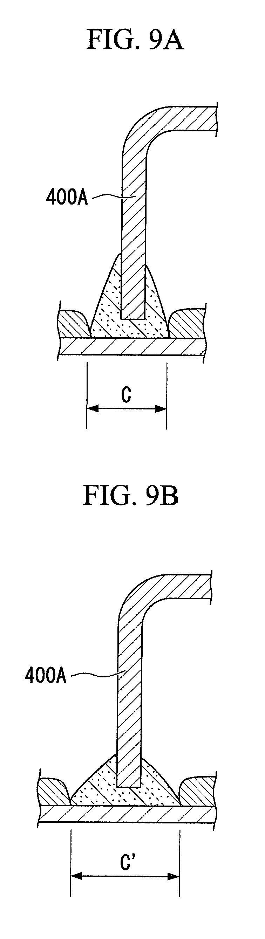

Fig. 9A is a sectional view that shows a soldered part in the mounting structure in Fig. 1.
Fig. 9B is a sectional view shows a soldered part in a conventional example as a comparative example for Fig. 9A.

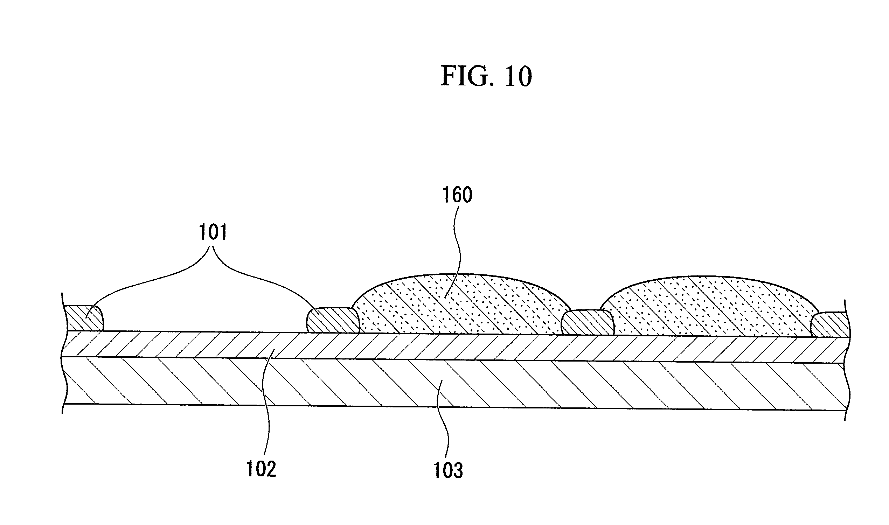

Fig. 10 is a sectional view that shows a soldered part in the mounting structure shown in Fig. 1.

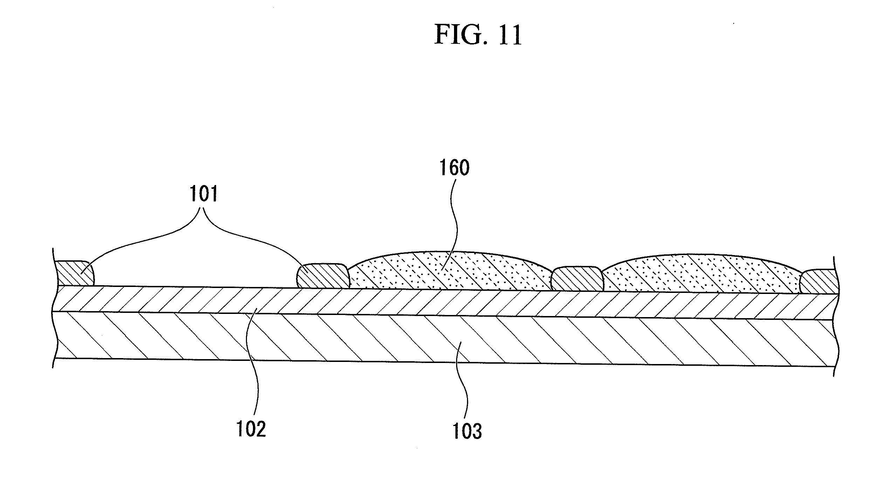

Fig. 11 is a sectional view that shows a soldered part in a mounting structure due to a generally known method.

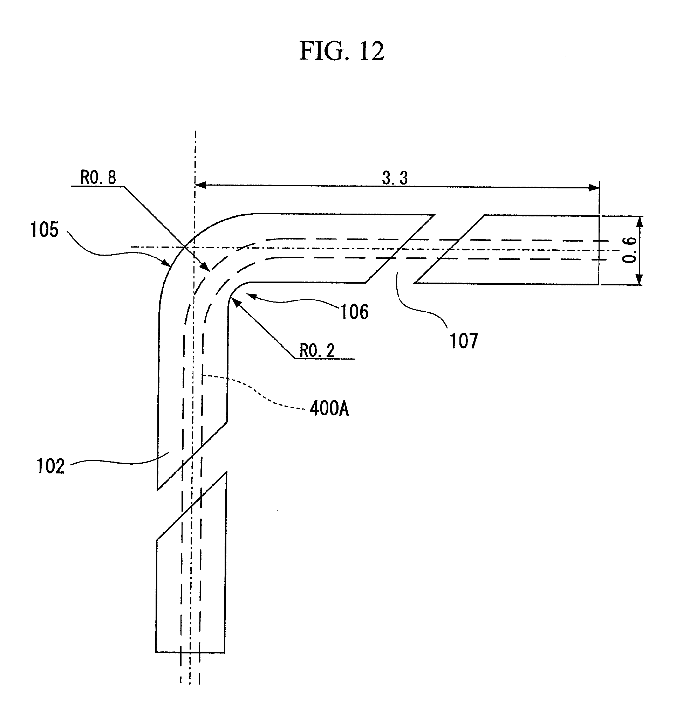

Fig. 12 is a plan view that shows a footprint shape at a corner in the mounting structure shown in Fig. 1.
Fig. 13 is a perspective view of a shield frame mounting structure in a conventional example.

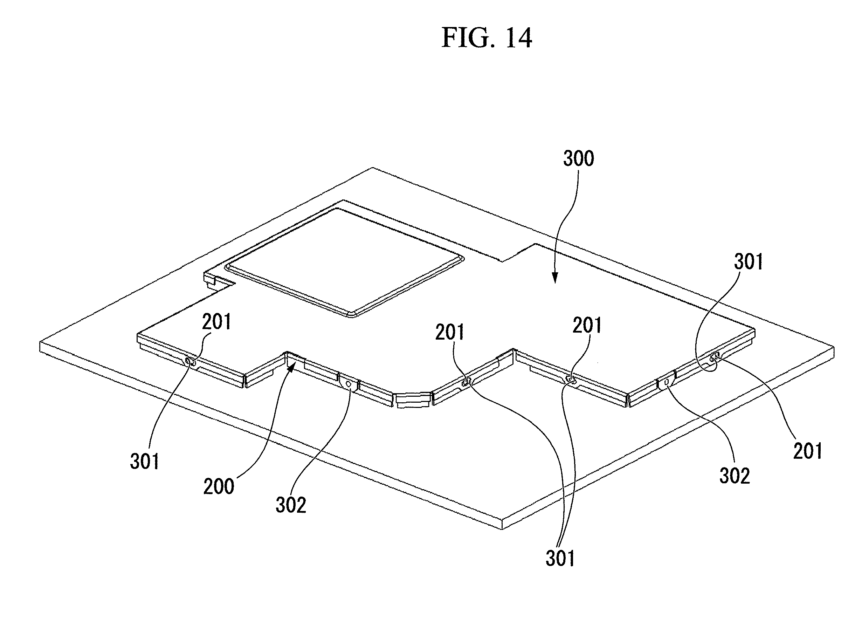

Fig. 14 is a perspective view of the mounting structure shown in Fig. 13, to which a frame cover is attached.

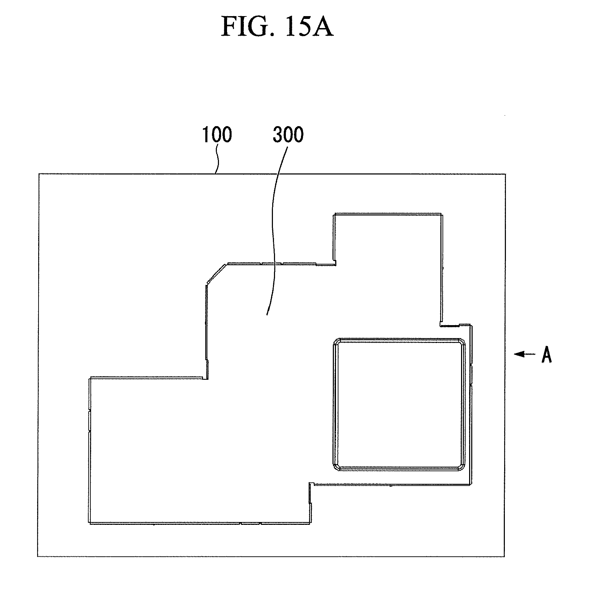

Fig. 15A is a plan view of the mounting structure shown in Fig. 13, to which the frame cover is attached.

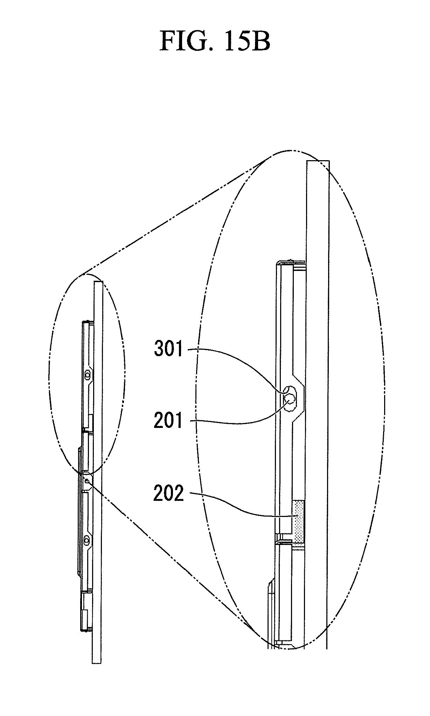

Fig. 15B shows a view observed along an arrow A in Fig. 15A, and an enlarged view of a main part thereof.
Figs. 16A is a plan view of the mounting structure in Fig. 13 from a different direction.
Fig. 16B is a view observed along an arrow A in Fig. 16A.
Fig. 16C is a view observed along an arrow B in Fig. 16A.
Fig. 16D is a view observed along an arrow C in Fig. 16A.
Fig. 16E is a view observed along an arrow D in Fig. 16A.

### MODE FOR CARRYING OUT THE INVENTION

### Structure

Fig. 1 is a perspective view of a typical general structure of a mounting board that employs a shield frame (or a large shield) formed by a drawing process and is built in a cellular phone (i.e., electronic portable device), as a best mode of embodiments in accordance with the present invention. On a circuit board 100, a "drawing" (drawing-process-type) shield frame 400 (formed by a drawing process), semiconductor components 110a to 110f, and other semiconductor or electronic components (not shown) are mounted.

The drawing shield frame 400 is fastened to the circuit board 100 on which electronic components (such as the semiconductor components) 110a to 110f are mounted. The drawing shield frame 400 includes (i) a side plate part 400A that extends so as to be arranged vertically from the circuit board 100 and surround the electronic components 110a to 110f, and (ii) a beam 400B that extends from the edge of the side plate part 400A toward an inner area that contains the electronic components.

The side plate part 400A employs a so-called "flangeless structure", that is, a base end part K that faces the circuit board 100 has no flange part that extends laterally. The side plate part 400A is utilized as an end part fixed to the circuit board 100 by soldering.

On the outer surface of the side plate part 400A, protrusions 401 are formed, which are utilized to attach a cover specialized for the shield formed by a drawing process, that is explained later. Although inner-R parts 402 and outer-R parts 403 are produced as shown in Fig. 1, they are continuously joined to the other outer-peripheral wall surface 404. Therefore, no electromagnetic wave leakage from the outer-peripheral wall surface occurs, and the inner area is not affected by the outside environment.

In addition, intermediate beams 405 are provided in the inner area surrounded by the side plate part 400A. Inner walls 406 are attached to the intermediate beams 405 so as to prevent transmission and reception of electromagnetic noise between functional unit sections in the shield frame, which have a predetermined size. According to such a structure, the semiconductor components can be contained in a single shield frame, where they need to be individually shielded if such a structure is not employed.

Fig. 2 is a perspective view of the large shield (formed by a drawing process) shown in Fig. 1, to which a cover 500 for such a drawing-process-type shield is attached. The cover 500 is attached by fitting the protrusions 401 of the drawing shield frame 400 to fitting holes 501. In addition, a few connection contacts 502 utilized to reliably establish electrical connection are provided, so that electrical connection between the shield frame formed by a drawing process and the cover suitable therefor can be reliably established.

As shown in Fig. 2, it can be understood that while the above cover 500 is attached to the shield frame, the semiconductor components mounted inside the shield frame are in a completely shielded state.

Figs. 3A to 3C are diagrams to show the mounting structure with the attached cover. Fig 3A is a plan view. Fig. 3B shows a view observed along an arrow A in Fig. 3A. Fig. 3C is an enlarged view of a main part of Fig 3A.

Figs. 4A to 4E are diagrams to show the mounting structure with the detached cover and especially the side plate part 400A in this state. Fig 4A is a plan view. Fig. 4B shows a view observed along an arrow A in Fig. 4A. Fig. 4C shows a view observed along an arrow B in Fig. 4A. Fig. 4D shows a view observed along an arrow C in Fig. 4A. Fig. 4E shows a view observed along an arrow D in Fig. 4A.

As shown in these figures, inevitable holes in a shield frame formed by a folding process are not produced in the present arrangement.

Below, a reason that the present invention can achieve a high mounting density of components will be explained with reference to Figs. 5A to 12.

For Figs. 5A and 5B, Fig. 5A is a sectional view of a flangeless side plate part 400A of the drawing shield frame 400 according to the present invention, and Fig. 5B is a sectional view of a wall surface that has a flange in a conventional drawing shield frame 600.

As shown in the figures, since soldering of the shield frame having such a flange is performed by means of a flange part 601, a corresponding land width B required for the relevant mounting should be larger than a land width A assigned to the flangeless side plate part 400A of the drawing shield frame. Therefore, the shield frame having the flange has a relatively large occupied area on the circuit board, which reduces the area that can be used to mount semiconductor components or electronic components in the entire area of the circuit board. This makes it difficult to realize the high mounting density of mounted components.

However, the shield having a flange has a merit such that the form in the height direction is determined in a post-process after a press molding process, and cutting of an outer-peripheral part may be performed in a final punching process. In this case, accuracy in the dimension in the height direction and the flatness of the flange surface can be high, and thus a preferable soldering performance can be relatively easily obtained.

In contrast, it is difficult for the shield having no flange to determine the form in the height direction in a post-process, and thus the form in the height direction is determined by means of an outer shape cutting process and a following drawing process. Therefore, in comparison with the shield having the flange, accuracy in the flatness of the relevant lower surface tends to be degraded. As shown in Fig. 6, the present invention solves such a problem by absorbing an odd-shaped part P (at the lower surface) into the soldered part.

Fig. 6 shows appearance from a surface layer of the circuit board to the relevant shield, where the side plate part 400A of the drawing shield frame 400, a solder layer 160, solder resist portions 101 on the surface layer of the circuit board 100, and an outermost conducting layer 102 and an insulating layer 103 of the surface layer are arranged in order from the top to bottom in the figure.

Fig. 7 shows a mounting structure that employs a normal amount of solder. When the height of solder is insufficient as shown in Fig. 7, an odd-shaped part cannot be satisfactorily absorbed. Such an odd-shaped part at the lower surface of the side plate part can be absorbed by providing a higher solder wet area in comparison with ordinary cases. In order to provide a higher solder wet area, the height of molten solder at a footprint which is connected to the solder should be large. Therefore, the present invention provides a dashed footprint pattern.

Fig. 8 shows an outer wall of a shield frame and a footprint pattern in accordance with the present invention. Along the side plate part 400A, solder resist openings 102 (i.e., footprint) are arranged in a dashed form. In addition, solder printable areas 104 are each slightly larger than the corresponding solder resist openings 102. Accordingly, it is possible to supply an increased amount of solder.

Additionally, in Fig.8, the height of solder that rises up the side plate part can also be increased by narrowing the resist openings in the cross-sectional direction.

Figs. 9A and 9B show soldered parts in the mounting structure of Fig. 1 and a mounting structure of a comparative (i.e., conventional) example therefor. Fig. 9A is a sectional view that shows the soldered part in the mounting structure of Fig. 1, and Fig. 9B is a sectional view that shows the soldered part in the comparative example.

If a width C shown in Fig. 8 is increased to C' as shown in Fig. 9A, the relevant solder extends transversally, and thus a sufficient height of solder that rises up the side plate part cannot be obtained. Therefore, it is appropriate to employ a narrow soldered part having a width (e.g., C in Figs. 8 and 9A) within a predetermined range, so as to obtain a sufficient height of solder that rises upward.

Fig. 10 is a schematic diagram (for the present invention) that shows a state in which the amount of solder is increased while no shield frame is provided. Fig. 11 is a schematic diagram for a generally known method in which each solder resist opening coincide with a corresponding mask opening (i.e., solder printable area).

As shown in Fig. 10, the maximum height of molten solder can be increased due to an increased amount of solder and the relevant surface tension.

Fig. 12 shows a specific footprint shape at a corner. In the footprint shape at a corner 105, the inner corner 106 thereof has an extremely small radius R of curvature of 0.2 mm in comparison with that of 0.8 mm of the side plate part 400A. Assuming that the side plate part 400A has a thickness of 0.2 mm, R of the inner corner of the shield frame is 0.6 mm, which is greater than the above R of 0.2 mm. According to such an arrangement, mounted components can be arranged up to each corner.

In addition, since the width of the solder resist opening at each corner is smaller than the width of the solder resist opening at the other positions, the height of the solder increases at each corner, so that a preferable soldering performance can be obtained. Additionally, when employing inclined slits 107, solder in the vicinity of each corner can be reliably collected at the corner.

In the above-described structure, regarding the solder applied to the side plate part 400A as shown in Fig. 12, it is preferable to secure a height of the molten solder to be 0.1 mm or greater. In addition, in the structure of Fig. 12, it is preferable for the footprint to have a width less than a value obtained by adding 0.4 mm to the plate thickness of the side plate part 400A.

According to the above arrangement, the height and width of soldered parts for the side plate part 400A are appropriately determined, so that the occupied area of the soldered parts can be as small as possible while securing a desired strength for fixing the side plate part 400A. Therefore, it is possible to improve the space efficiency.

In accordance with the above-described structure, high shielding performance and preferable soldering performance can be obtained while securing a mounting area equivalent to that secured for a shield frame fabricated by a folding process.

According to the present invention, in comparison with shield frames fabricated by the folding process, the mechanical strength of the frame itself, in particular, the strength in a twisting direction is increased. Therefore, a desired strength of the board after mounting can also be easily obtained. Furthermore, since the outer periphery of the shield frame closely and uniformly contacts the circuit board, which prevents leakage of water or resin through a gap between the shield frame and the board. Therefore, the present invention produces distinctive effects such that resin that fills the shield frame does not leak outside the frame, and no water or the like penetrates from the outside to the inside of the frame.

In addition, although the solder itself is arranged in a dashed form, it closely contacts the circuit board and thus gaps are hardly ever produced. Even if a few gaps are produced, they are present at the solder resist area which has water-repellent and oil-repellent properties. Therefore, penetration of water or resin into the inside of the shield frame does not occur under a pressureless condition.

Therefore, in the present invention, (i) reliable electromagnetic shielding is possible even for a large shield frame having a complex form, (ii) both reliable electromagnetic shielding and downsizing can be realized for a large shield frame, (iii) the relevant structure can be implemented utilizing a mounting area equivalent to that in conventional shield frames fabricated by a folding process, and (iv) simple waterproofing inside the shield frame can be performed.

In the above-described embodiment, protrusions are provided at the shield frame and fitting holes are provided at the cover. However, fitting holes may be provided at the shield frame and protrusion may be provided at the cover. In this case, no protrusions are provided at the outside of a shield frame formed by a drawing process, which makes it easy to fabricate the shield frame. As a demerit, outer wall surfaces of the shield frame should have holes, through which water or resin can flow.

Additionally, in the above-described embodiment, it is preferable to make the shield frame of a metal that has a small surface resistance, for example, stainless steel, aluminum, aluminum alloy, copper alloy, or titanium alloy.

When employing stainless steel, it does not provide sufficient soldering performance. Therefore, tinned or solder-plated stainless steel is preferable. Copper alloy such as copper-nickel-zinc alloy or brass needs no surface treatment. However, in this case, shape stability is not high. The same applies to the aluminum alloy.

Furthermore, in the above-described embodiment, the shield frame and its cover are separately arranged. However, they may be integrated into a single component. Although such a structure causes problems such that internal components cannot be checked after the mounting and it is difficult to apply resin, the number of necessary components can be decreased, which can reduce the manufacturing cost.

### INDUSTRIAL APPLICABILITY

In accordance with the present invention, reliable electromagnetic shielding is possible even for a large shield frame having a complex form, and both the reliable electromagnetic shielding and downsizing can be realized for a large shield frame. In addition, the relevant structure can be implemented utilizing a mounting area equivalent to that in conventional shield frames fabricated by a folding process, and simple waterproofing inside the shield frame can be performed.

### Reference Symbols

- 100: circuit board
- 110a to 110f: electronic component
- 400: shield frame
- 400A: side plate part

## Claims

1. A shield frame comprising:
a side plate part that extends so as to be arranged vertically from a circuit board, on which electronic components are mounted, and to surround lateral sides of the electronic components,
wherein the side plate part has a base end part that faces the circuit board, and the base end part has a flangeless structure and functions as an end part fixed to the circuit board by soldering.

2. The shield frame in accordance with claim 1, wherein:
the shield frame is made of metal and is formed by a drawing process.

3. The shield frame in accordance with claim 2 wherein:
the shield frame is made of the metal that is selected from a group consisting of stainless steel, aluminum, aluminum alloy, copper alloy, and titanium alloy.

4. A shield frame mounting structure in which a shield frame in accordance with any one of claims 1 to 3 is provided, wherein:
the base end part of the side plate part is fixed to the circuit board by soldering; and
as for an amount of solder applied to the shield frame, a height of the molten solder is 0.1 mm or greater.

5. A shield frame mounting structure in which the shield frame in accordance with any one of claims 1 to 3 is provided, wherein:
the base end part of the side plate part is fixed to the circuit board by soldering; and
a footprint utilized to connect the shield frame to the board has a width less than a value obtained by adding 0.4 mm to a plate thickness of the shield frame.

6. An electronic portable device that comprises the shield frame in accordance with any one of claims 1 to 3.

7. An electronic portable device that comprises the shield frame mounting structure in accordance with any one of claims 4 and 5.
